# EUROPÄISCHE PATENTSCHRIFT

(11) **EP 2 153 111 B1**
(45) Veröffentlichungstag und Bekanntmachung des Hinweises auf die Patenterteilung: **09.02.2011**
(21) Anmeldenummer: 08760255.3
(22) Anmeldetag: 30.05.2008
(51) Int. Cl.: F21K 99/00, F21V 31/04, H01L 33/56

(54) **LEUCHTKÖRPER-SILICON-FORMTEIL**
SILICONE-MOULDED PART COMPRISING LUMINOUS BODIES
PIÈCE MOULÉE EN SILICONE À ÉLÉMENTS LUMINEUX

(30) Priorität: 01.06.2007 DE 102007025749
(43) Veröffentlichungstag der Anmeldung: 17.02.2010
(73) Patentinhaber: Wacker Chemie AG, 81737 München (DE)
(72) Erfinder: DAUTH, Jochen, 84489 Burghausen (DE); MÜLLER-REES, Christoph, 82049 Pullach (DE); OCHS, Christian, 84489 Burghausen (DE)
(74) Vertreter: Schuderer, Michael
(86) Internationale Anmeldenummer: PCT/EP2008/056665
(87) Internationale Veröffentlichungsnummer: WO 2008/145718

(56) Entgegenhaltungen:
- EP-A- 1 045 453
- EP-A- 1 249 875
- DE-A1- 3 019 239
- US-A1- 2003 042 844
- US-A1- 2003 071 366

## Beschreibung

Die Erfindung betrifft Leuchtkörper-Silicon-Formteile, welche mehrere Leuchtkörper in einer Siliconmatrix eingeschlossen enthalten.

LED-Leuchtkörper (LED = Light Emitting Diode) oder auch Leuchtdioden genannte Leuchtkörper sind lichtabstrahlende, elektronische Bauelemente. Die LED-Technologie zeichnet sich dadurch aus, dass über einen weiten Bereich des elektromagnetischen Spektrums Leuchtkörper zur Verfügung stehen, wobei die einzelnen LED-Leuchtkörper sehr spezifisch in einem engen Spektralbereich abstrahlen. Dies macht LED-Leuchtkörper für viele Anwendungen interessant, beispielsweise zum Initiieren von chemischen Reaktionen und biologischen Prozessen. Weitere Vorteile bestehen in der geringen Wärmeabgabe, höheren Lichtausbeute und längeren Lebensdauer.

Zum Schutz vor Umwelteinflüssen ist bekannt einzelne Leuchtdioden mit Siliconen zu verkapseln: Aus der US 6,916,889 B2 ist bekannt, zur Einkapselung von LEDs vernetzbare epoxyfunktionelle Silicone einzusetzen. In der WO 2006/055196 A1 wird die Einkapselung von LED-Leuchtkörpern mit photopolymerisierbarem Silicon beansprucht. Die EP 1 684 363 A2 beschreibt die Verkapselung von LEDs mit vernetzbarem Silicon, wobei in einem ersten Schritt der LED-Chip mit einem vernetzten Siliconkautschuk verkapselt wird und anschließend eine zweite Schicht aus vernetztem Siliconharz aufgebracht wird. Die DE 3019239 A1 beschreibt die Umhüllung einzelner Halbleiterbauelemente mit zwei Schichten von denen eine Schicht aus einem harten Kunststoff besteht. Konkret beschrieben wird eine Umhüllung mit einer ersten, weichen Schicht aus Silicon oder Epoxidharz und einer zweiten, harten Schicht aus Silicon, Epoxidharz oder Thermoplast. In der US 2005/0130336 A1 werden einzelne LEDs mit einem harten, transparenten linsenförmigem Material verkapselt und der dabei gebildete Hohlraum zwischen Kapsel und LED mittels einer Nadel mit weichem Material, beispielsweise flüssigem Silicon, befüllt. Ein analoges Vorgehen wird in der DE 19945675 A1 beschrieben, wobei der einzelne LED-Chip mit einer optischen Epoxidharz-Linse verkapselt wird und der Hohlraum mit flüssigem oder gelatineartigem Silicon befüllt wird. In der EP 1657758 A2 wird beschrieben, einen oder mehrere LEDs auf einen Träger aufzubringen und jede einzelne LED mit einer inneren, weichen Linse und einer äußeren, harten Linse auszurüsten. Träger, weiche und harte Linse können aus Silicon gebildet werden.

Die EP 1 249 875 A offenbart ein Leuchtkörper-Silicon-Formteil, welches einen Leuchtkörper in einer Matrix engschlossen enthält, wobei die Matrix aus einer inneren, weichen Silikonmatrix A gebildet wird, welche von einer härteren Matrix B umgeben wird.

Nachteilig bei der Verkapselung einzelnen LED-Chips ist der hohe apparative und verfahrenstechnische Aufwand der dabei zu betreiben ist. Man erhält damit zwar LED-Chips welche wirksam gegen Umwelteinflüße geschützt sind, aber beim Einsatz von mehreren, mit elektrischen Leitern verbundenen und mit Anschlüssen versehenen LED-Chips, sind Leiter und Anschlüsse nach wie vor Umwelteinflüssen ungeschützt ausgesetzt.

Die DE 102005050947 A1 beschreibt ein Leuchtelement, bei dem mehrere LED-Chips miteinander verbunden sind und in einem Kunststoff- oder Glasgehäuse eingeschlossen sind, welches mit einem inerten Material, wie Silicon, befüllt ist. In der US 2003/0042844 A1 werden mehrere LED-Chips auf dem Grund eines wannenartigen Rahmens angeordnet und die Wanne mit Epoxidharz ausgegossen. Aus der DE 3827083 A1 ist die Herstellung von flächenhaften Strahlern bekannt, wobei mehrere LEDs auf einer transparenten Montageplatte aufgebracht sind und mittels einer Gußform auf jede LED Siliconharz zur Ausbildung eines Reflektorkörpers aufgegossen wird, und schließlich die Reflektorkörper mit reflektierendem Material beschichtet werden. Aus der DE 20 2006 001 561 U1 sind schlauchförmige Leuchtbänder bekannt, bei denen mehrere über ein Kabel verbundene Leuchtdioden in einem Siliconschlauch eingeschlossen sind.

Nachteilig bei den beschriebenen Formkörpern ist vor allem deren aufwändige Herstellung und die geringe Flexibilität bezüglich der Ausformung der Formkörper, beispielsweise bei den wannenartigen Formkörpern bzw. den mit LEDs befüllten Glasbehältern. Nachteilig ist auch der unzureichende Schutz von leitenden Verbindungselementen zwischen den Leuchtkörpern bzw. von Anschlüssen.

Es bestand die Aufgabe Leuchtkörper, insbesondere auf der Basis von LEDs, in einer Form zur Verfügung zu stellen, welche deren Einsatz in unterschiedlichen Anwendungsbereichen möglich macht. Die Materialien sollten so beschaffen sein, dass sie unterschiedlichsten Umwelteinflüssen, seien es physikalische, chemische oder biologische, über einen langen Zeitraum wirksam standhalten. Weiter sollten die Materialien so gewählt werden, dass über einfache Verfahren flexible Formteile beliebiger Formgestalt und Dimensionierung erhalten werden können. Eine weitere Aufgabe bestand darin, nicht nur die einzelnen Leuchtkörper, sondern auch elektrische Verbindungen zwischen den Leuchtkörpern und Anschlüsse an Stromquellen wirksam zu schützen. Eine weitere Aufgabe war es, Streuverluste innerhalb des Formkörpers zu minimieren.

Gegenstand der Erfindung sind Formteile, welche mehrere Leuchtkörper in einer Siliconmatrix eingeschlossen enthalten, wobei die Siliconmatrix aus einer inneren, weichen Siliconmatrix A gebildet wird, welche von einer oder mehreren, härteren Siliconmatrices B umgeben wird, und die Siliconmatrix B gegebenenfalls mit einem Topcoat C beschichtet ist.

Die Formgestalt der Leuchtkörper-Silicon-Formteile ist beliebig und der jeweiligen Anwendung angepasst. Sie können in Form von Schläuchen vorliegen, als Rohre, Bänder, als Platten oder in Form von Matten. Bevorzugt werden mit mehreren Leuchtkörpern, insbesondere mehreren LEDs, bestückte Schläuche oder Bänder, wobei diese Leuchtkörper in einer besonders bevorzugten Ausführungsform in einer solchen Weise zueinander versetzt angeordnet werden (z.B. verdrillt), dass sie den Umgebungsraum vollständig und homogen ausleuchten.

Geeignete Leuchtkörper sind beliebige strahlungsemittierende Bauelemente wie Fadenglühlampen, Halogenlampen, Niedrigdruckentladungslampen, Hochdruckentladungslampen, Fluoreszenzleuchten, Neonleuchten, sowie Injektions-Lumineszenzlampen, vorzugsweise strahlungsemittierende Halbleiterbauelemente von organischen oder anorganischen Halbleitern, sogenannte LEDs. Bei den LEDs kann es sich um bereits mit Kunststoff, meist Silicon, verkapselte Dioden oder um unverkapselte Dioden handeln.

Geeignete LED-Leuchtkörper sind solche, die im InfrarotBereich, im sichtbaren Bereich oder im UV-Bereich strahlen. Die Auswahl hängt von der beabsichtigten Anwendung ab. Die in der Matrix eingebetteten LED-Leuchtkörper können bei gleicher Wellenlänge emittieren. Es können aber auch LED-Leuchtkörper mit unterschiedlicher Strahlungscharakteristik miteinander kombiniert werden.

Im allgemeinen sind mehrere Leuchtkörper, insbesondere LEDs, miteinander leitend verbunden, in Reihe und/oder parallel geschaltet. Die Leuchtkörperanordnung kann mit Sensoren verbunden sein, sowie mit Mess-/Steuerungseinrichtungen. Die Anzahl der Leuchtkörper und deren Anordnung zueinander hängt von deren Anwendung ab. Die LED-Leuchtkörper können kontinuierlich oder gepulst betrieben werden.

Die Anordnung der Leuchtkörper, einschließlich der elektrisch leitenden Verbindungen zwischen den Leuchtkörpern, und vorzugsweise auch die Anschlüsse der Leuchtkörperanordnung, sind vollständig in der inneren Siliconmatrix A eingeschlossen und letztere von der äußeren Siliconmatrix B umgeben. Die Formteile zeichnen sich dadurch aus, dass sich zwischen dem Leuchtkörper und der Siliconmatrix A bzw. zwischen Siliconmatrix A und Siliconmatrix B kein weiteres Medium, beispielsweise Luft oder Wasser, befindet.

Die Siliconmatrix in Form der Bestandteile Siliconmatrix A und Siliconmatrix B ist hoch transparent, wobei die Transmission im Bereich einer Wellenlänge von 290 - 1200 nm > 50 % beträgt. Bevorzugt wird eine Transmission von > 85 % im Wellenlängen-Bereich von 300 bis 800 nm. Besonders bevorzugt wird eine Transmission von > 90 % im Wellenlängen-Bereich von 380 bis 750 nm.

Die Siliconmatrix A ist auf den Leuchtkörper hin optimiert und soll neben der Schutzfunktion für die elektronischen Bauteile (Schockabsorption), die Lichtausbeute optimieren (Brechungsindex-Anpassung) und die Wärmeabfuhr erleichtern. Weiter ist von Bedeutung, dass die Leuchtkörper dauerhaft, während der gesamten Betriebszeit der Leuchtkörper, von der Siliconmatrix fest umschlossen bleiben, und Luft- und Wassereinschlüsse, die zu diffusen Lichtstreuungseffekten führen, verhindert werden.

Die innere Siliconmatrix A ist weich mit einer Shore Härte A (DIN 53 505 / ISO 868) von kleiner oder gleich 10, oder, falls es sich um ein flüssiges Siliconöl handelt, einer durchschnittlichen Viskosität (bei 23 °C und 1013 mbar) von 1 bis 100x10⁶ mPa.s. Vorzugsweise beträgt die Shore-Härte A unter 5 bzw. die durchschnittliche Viskosität (bei 23 °C und 1013 mbar) von 10 bis 10x10⁶ mPa.s.

Geeignete Materialien für die innere Siliconmatrix A sind Siliconöle, das sind im allgemeinen Dialkylpolysiloxane der Struktur R₃SiO[-SiR₂O]ₙ-SiR₃ mit einer Kettenlänge von n > 2. Die Alkylreste R können gleich oder verschieden sein und haben im allgemeinen 1 bis 4 C-Atome und können gegebenenfalls substituiert sein. Die Alkylreste R können auch teilweise durch andere Reste ersetzt sein, vorzugsweise durch Arylreste, welche gegebenenfalls substituiert sind, oder durch Trialkylsiloxy-Gruppen bei verzweigten Siliconölen. Beispiele sind Methylsiliconöle (CH₃)₃SiO[-Si(CH₃)₂O]ₙ-Si(CH₃)₃, Methylphenylsiliconöle (CH₃)₃SiO[-Si(CH₃)₂O]ₙ'-[-Si(C₆H₅)₂O]ₙ"-Si(CH₃)₃ oder (CH₃)₃SiO[-Si(CH₃)₂ O]ₙ'-[-Si(CH₃)(C₆H₅)O]ₙ"-Si(CH₃)₃ mit jeweils n'+ n " > 2, verzweigte Methylsiliconöle (CH₃)₃SiO[-Si(CH₃) (OSi(CH₃)₃)O]ₙ-Si(CH₃)₃, verzweigte Methylphenylsiliconöle (CH₃)₃SiO[-Si(C₆H₅) (OSi(CH₃)₃)O]ₙ-Si(CH₃)₃. Mit der Einführung von Arylgruppen und der Einstellung des Verhältnisses von Alkyl- zu Aryl-Gruppen kann der Fachmann in bekannter Weise den Brechungsindex der Siliconmatrix dem Leuchtkörper anpassen. Desweiteren können auch vorzugsweise an den Endgruppen funktionalisierte ("nicht-gestopperte") Polydimethylsiloxanöle verwendet werden. Solche Siliconöle sind im Handel erhältlich und mit bekannten Methoden herstellbar. Beispiele für kommerziell erhältliche Siliconöle sind die Wacker Siliconöle der Wacker Chemie AG.

Für die innere Siliconmatrix A geeignet sind auch Silicongele. Silicongele werden aus zwei gießbaren Komponenten hergestellt, welche bei Raumtemperatur in Gegenwart eines Katalysators vernetzen. Eine der Komponenten besteht im allgemeinen aus Dialkylpolysiloxanen der Struktur R₃SiO[-SiR₂O]ₙ-SiR₃ mit n ≥ 0, im allgemeinen mit 1 bis 4 C-Atomen im Alkylrest, wobei die Alkylreste ganz oder teilweise durch Arylreste wie den Phenylrest ersetzt werden können, und an einem oder an beiden Enden einer der endständigen Reste R durch eine polymerisierbare Gruppe wie die Vinylgruppe ersetzt ist. Ebenso können teilweise Reste R in der Siloxankette, auch in Kombination mit den Resten R der Endgruppen, durch polymerisierbare Gruppen ersetzt werden. Bevorzugt werden vinylendblockierte Polydimethylsiloxane der Struktur CH₂=CH₂-R₂SiO[-SiR₂O]n-SiR₂-CH₂=CH₂ eingesetzt.

Die zweite Komponente enthält einen Si-H-funktionellen Vernetzer. Die üblicherweise verwendeten Polyalkylhydrogensiloxane sind Copolymere aus Dialkylpolysiloxanen und Polyalkylhydrogensiloxanen mit der allgemeinen Formel R'₃SiO[-SiR₂O]ₙ-[SiHRO]ₘ-SiR'₃ mit m ≥ 0, n ≥ 0 und der Maßgabe, dass mindestens zwei SiH-Gruppen enthalten sein müssen, wobei R' die Bedeutung von H oder R haben kann. Es gibt demnach Vernetzer mit seitenständigen und endständigen SiH-Gruppen, während Siloxane mit R'= H, die nur endständige SiH-Gruppen besitzen, auch noch zur Kettenverlängerung verwendet werden. Als Vernetzungskatalysator sind geringe Mengen einer platinorganischen Verbindung enthalten. Durch das Mischen der Komponenten wird die Vernetzungsreaktion ausgelöst und das Gel gebildet. Diese Vernetzungsreaktion kann durch das Einwirken von Wärme und/oder durch elektromagnetische Strahlung, vorzugsweise UV-Strahlung, beschleunigt werden. UV-LEDs selbst können dabei die Vernetzungsreaktion von Gelen induzieren. Bei den Silicongelen handelt es sich um besonders weiche Materialien, besonders bevorzugt mit einer Shore-Härte 00 von unter 50 (DIN 53 505 / ISO 868), am meisten bevorzugt um solche mit einem Penetrationswert gemäß DIN ISO 2137 von > 10 mm/10 (bei 9,38 g Viertelkonus und 5 s Einwirkzeit). Geeignete Silicongele sind im Handel erhältlich, beispielsweise unter dem Handelsnamen WACKER SilGel^{®} der Wacker Chemie AG, München.

Für die innere Siliconmatrix A werden die genannten Siliconöle und Silicongele bevorzugt.

Die genaue Zusammensetzung der Siliconmatrix A hängt von der Strahlungscharakteristik der mitverwendeten LEDs ab, und es werden solche Siliconmaterialien eingesetzt, welche im entsprechenden Wellenlängenbereich optimale Transparenz bedingen. Wichtig hierbei ist, dass ein dauerhafter Kontakt zwischen der inneren Siliconmatrix A und dem Leuchtkörper gegeben ist, da etwaige Delaminationserscheinungen aufgrund der damit einhergehenden, deutlich reduzierten Lichtausbeuten unerwünscht sind. Aus diesem Grund sind als Materialien für die innere Siliconmatrix A selbsthaftende Systeme oder solche mit hoher O-berflächenklebrigkeit bevorzugt. Die Materialien für die Siliconmatrix A können auch mittels Zusatz von Additiven optimiert werden. Beispiele hierfür sind lumineszierende Additive zur Lichtwellenlängenanpassung, Metall- oder Metalloxid-Partikel oder ähnliche Mikropartikel zur Variation des Brechungsindex, zur Optimierung der Lichtausbeute (z.B. unter Verwendung reflektierender Partikel, die eine gleichmäßige Streuung des vom Leuchtkörper emittierten Lichtes nach außen bewirken) und zur Optimierung der Wärmeabführung. Zur Einstellung der mechanischen und rheologischen Eigenschaften können gegebenenfalls noch geringe Mengen an hochdisperser Kieselsäure oder die Siliconelastomermatrix verstärkende Füllstoffe, wie z.B. Siliconharzpartikel bestehend aus MT-, MQ- oder DT-Einheiten, eingesetzt werden. Die Schichtdicke der inneren Siliconmatrix A wird der entsprechenden Anwendung angepasst und beträgt im allgemeinen zwischen 0,5 und 50 mm, bevorzugt zwischen 1 und 20 mm.

Die äußere Siliconmatrix B ist auf die entsprechende Anwendung hin optimiert, insbesondere bezüglich mechanischer Festigkeit, chemischer, biologischer, physikalischer (schmutzabweisend, kratzfest) Resistenz, unter Erhalt der notwendigen Transparenz.

Die äußere Siliconmatrix B kann, bis auf die genannten Siliconöle und Silicongele, aus den gleichen Silicontypen bestehen wie die innere Siliconmatrix A, mit dem Unterschied, dass die Shore-Härte A der äußeren Siliconmatrix B mehr als 10 beträgt, und für den Fall, dass die innere Siliconmatrix A, ebenfalls aus einem bei Normalbedingungen (23/50 DIN 50014) festen Silicontyp besteht, die Differenz zwischen den Shore-Härten A von innerer Siliconmatrix A und äußerer Siliconmatrix B mindestens 5 Shore-Härte-Punkte, bevorzugt mindestens 10, insbesondere mindestens 20 beträgt.

Für die Siliconmatrix B bevorzugte Silicone, aber gegebenenfalls auch für die Siliconmatrix A unter den genannten Bedingungen (geringere Shore-Härte A) einsetzbare Silicone, sind vernetzte Siliconkautschuke, welche durch Kondensations- oder Additionsreaktion oder radikalisch vernetzen. Die Vernetzungsreaktion kann kationisch, mittels entsprechender Katalysatoren, oder radikalisch, mittels Peroxiden, oder durch Strahlung, insbesondere UV-Strahlung, oder thermisch initiert werden. Systeme, welche zu vernetzten Siliconkautschuken führen, sind vorzugsweise als 1- oder 2-, aber auch als Mehrkomponenten-Systeme im Handel erhältlich. Geeignet sind auch Siliconhybridpolymere.

Kondensationsvernetzende Siliconkautschuk-Systeme enthalten
a) kondensationsfähige Endgruppen aufweisende Organopolysiloxane,
b) gegebenenfalls je Molekül mindestens drei an Silicium gebundene hydrolysierbare Gruppen aufweisende Organosiliciumverbindungen, sowie
c) Kondensationskatalysatoren.

Geeignete vernetzte Siliconkautschuke, welche durch Kondensationsreaktion vernetzen, sind bei Raumtemperatur vernetzende 1-Komponenten-Systeme, sogenannte RTV-1-Siliconkautschuke. Bei den RTV-1-Siliconkautschuken handelt es sich um Organopolysiloxane mit kondensationsfähigen Endgruppen, welche in Gegenwart von Katalysatoren unter Kondensation bei Raumtemperatur vernetzen. Am gebräuchlichsten sind Dialkylpolysiloxane der Struktur R₃SiO[-SiR₂0]ₙ-SiR₃ mit einer Kettenlänge von n > 2. Die Alkylreste R können gleich oder verschieden sein und haben im allgemeinen 1 bis 4 C-Atome und können gegebenenfalls substituiert sein. Die Alkylreste R können auch teilweise durch andere Reste ersetzt sein, vorzugsweise durch Arylreste, welche gegebenenfalls substituiert sind, und wobei die Alkyl-(Aryl)-Gruppen R teilweise durch zur Kondensations-Vernetzung fähige Gruppen ausgetauscht sind, beispielsweise Alkohol-, Acetat-, Amin- oder Oximreste. Die Vernetzung wird mittels geeigneter Katalysatoren, beispielsweise Zinn- oder Titankatalysatoren katalysiert. Geeignete RTV-1-Siliconkautschuke sind im Handel erhältlich, beispielsweise die entsprechenden Typen der ELASTOSIL® A-, E- oder N-Reihe der Wacker Chemie AG.

Geeignete vernetzte Siliconkautschuke, welche durch Kondensationsreaktion vernetzen, sind bei Raumtemperatur vernetzende 2-Komponenten-Systeme, sogenannte RTV-2-Siliconkautschuke. RTV-2-Siliconkautschuke erhält man mittels Kondensationsvernetzung von mehrfach mit Hydroxygruppen substituierten Organopolysiloxanen in Gegenwart von Kieselsäureestern. Als Vernetzer können auch Alkylsilane mit Alkoxy-, Oxim- Amin- oder Acetatgruppen eingesetzt werden, welche in Anwesenheit von geeigneten Kondensations-Katalysatoren, beispielsweise Zinn- oder Titankatalysatoren mit den Hydroxygruppen-terminierten Polydialkylsiloxanen vernetzen. Geeignete kondensationsvernetzende RTV-2-Siliconkautschuke sind im Handel erhältlich, beispielsweise die entsprechenden Typen der ELASTOSIL® RT-Reihe der Wacker Chemie AG.

Beispiele für die in RTV-1 und RTV-2 Siliconkautschuk enthaltenen Polydialkylsiloxane sind solche der Formel (OH)R₂SiO[-SiR₂O]ₙ-SiR₂(OH) mit einer Kettenlänge von n > 2, wobei die Alkylreste R gleich oder verschieden sein können, im allgemeinen 1 bis 4 C-Atome enthalten und gegebenenfalls substituiert sein können. Die Alkylreste R können auch teilweise durch andere Reste ersetzt sein, vorzugsweise durch Arylreste, welche gegebenenfalls substituiert sind. Vorzugsweise enthalten die Polydialkylsiloxane terminale OH-Gruppen, welche mit den Kieselsäureestern bzw. dem System Alkylsilan/Zinn(Titan)-katalysator bei Raumtemperatur vernetzen.

Beispiele für die in RTV-1 und RTV-2 Siliconkautschuken enthaltenen, hydrolysierbare Gruppen aufweisende Alkylsilane sind solche der Formel RₐSi(OX)₄₋ₐ, mit a = 1 bis 3 (bevorzugt 1), und X in der Bedeutung von R" (Alkoxyvernetzer), C(O)R " (A-cetatvernetzer), N=CR"₂ (Oxim-Vernetzer) oder NR"₂ (Aminvernetzer), wobei R " einen einwertigen Kohlenwasserstoffrest mit 1 bis 6 Kohlenstoffatomen bedeutet.

Additionsvernetzende Siliconkautschuk-Systeme enthalten
a) Organosiliciumverbindungen, die Reste mit aliphatischen Kohlenstoff-Kohlenstoff-Mehrfachbindungen aufweisen,
b) gegebenenfalls Organosiliciumverbindungen mit Si-gebundenen Wasserstoffatomen oder anstelle von a) und b)
c) Organosiliciumverbindungen, die Reste mit aliphatischen Kohlenstoff-Kohlenstoff-Mehrfachbindungen und Si-gebundene Wasserstoffatome aufweisen,
d) die Anlagerung von Si-gebundenen Wasserstoff an aliphatische Mehrfachbindung fördernde Katalysatoren und
e) gegebenenfalls die Anlagerung von Si-gebundenem Wasserstoff an aliphatische Mehrfachbindung bei Raumtemperatur verzögernde Mittel.

Geeignete vernetzte Siliconkautschuke, welche durch Additionsreaktion vernetzen, sind bei Raumtemperatur vernetzende 2-Komponenten-Systeme, sogenannte additionsvernetzende RTV-2-Silikonkautschuke. Additionsvernetzende RTV-2-Siliconkautschuke erhält man durch mit Pt-Katalysatoren katalysierte Vernetzung von mehrfach ethylenisch ungesättigten Gruppen, vorzugsweise Vinylgruppen, substituierten Organopolysiloxanen mit mehrfach mit Si-H-Gruppen substituierten Organopolysiloxanen in Gegenwart von Platinkatalysatoren.

Vorzugsweise besteht eine der Komponenten aus Dialkylpolysiloxanen der Struktur R₃SiO[-SiR₂O]n-SiR₃ mit n ≥ 0, im allgemeinen mit 1 bis 4 C-Atomen im Alkylrest, wobei die Alkylreste ganz oder teilweise durch Arylreste wie den Phenylrest ersetzt werden können, und an einem oder an beiden Enden einer der endständigen Reste R durch eine polymerisierbare Gruppe wie die Vinylgruppe ersetzt ist. Ebenso können teilweise Reste R in der Siloxankette, auch in Kombination mit den Resten R der Endgruppen, durch polymerisierbare Gruppen ersetzt werden. Bevorzugt werden vinylendblockierte Polydimethylsiloxane der Struktur CH₂=CH₂-R₂SiO[-SiR₂O]ₙ-SiR₂-CH₂=CH₂ eingesetzt.

Die zweite Komponente enthält einen Si-H-funktionellen Vernetzer. Die üblicherweise verwendeten Polyalkylhydrogensiloxane sind Copolymere aus Dialkylpolysiloxanen und Polyalkylhydrogensiloxanen mit der allgemeinen Formel R'₃SiO[-SiR₂O]ₙ-[SiHRO]ₘ-SiR'₃ mit m ≥ 0, n ≥ 0 und der Maßgabe, dass mindestens zwei SiH-Gruppen enthalten sein müssen, wobei R' die Bedeutung von H oder R haben kann. Es gibt demnach Vernetzer mit seitenständigen und endständigen SiH-Gruppen, während Siloxane mit R'= H, die nur endständige SiH-Gruppen besitzen, auch noch zur Kettenverlängerung verwendet werden.

Als Vernetzungskatalysator sind geringe Mengen einer platinorganischen Verbindung enthalten.

Geeignete RTV-Siliconkautschuke sind im Handel erhältlich, beispielsweise die entsprechenden Typen der ELASTOSIL® RT oder ELASTOSIL® LR (LSR-Siliconkautschuk) oder SEMICOSIL®-Reihe der Wacker Chemie AG.

Geeignete radikalisch oder durch Additionsreaktion vernetzende Siliconkautschuke sind die bei Temperaturerhöhung vernetzenden Festsiliconkautschuke (HTV).

Additionsvernetzende HTV-Siliconkautschuke erhält man durch die Vernetzung von mehrfach ethylenisch ungesättigten Gruppen, vorzugsweise Vinylgruppen, substituierten Organopolysiloxanen mit mehrfach mit Si-H-Gruppen substituierten Organopolysiloxanen in Gegenwart von Platinkatalysatoren.

Vorzugsweise besteht eine der Komponenten der peroxidisch oder additionsvernetzenden HTV-Siliconkautschuke aus Dialkylpolysiloxanen der Struktur R₃SiO[-SiR₂O]ₙ-SiR₃ mit n ≥ 0, im allgemeinen mit 1 bis 4 C-Atomen im Alkylrest, wobei die Alkylreste ganz oder teilweise durch Arylreste wie den Phenylrest ersetzt werden können und an einem oder an beiden Enden einer der endständigen Reste R durch eine polymerisierbare Gruppe wie die Vinylgruppe ersetzt ist. Es können aber auch Polymere mit seitenständigen bzw. mit seiten- und endständigen Vinylgruppen verwendet werden. Bevorzugt werden vinylendblockierte Polydimethylsiloxane der Struktur CH₂=CH₂-R₂SiO[-SiR₂O]ₙ-SiR₂-CH₂=CH₂ eingesetzt, sowie vinylendblockierte Polydimethylsiloxane der genannten Struktur, welche noch seitenständige Vinylgruppen tragen. Bei additionsvernetzenden HTV-Siliconkautschuken ist die zweite Komponente ein Copolymer aus Dialkylpolysiloxanen und Polyalkylhydrogensiloxanen mit der allgemeinen Formel R'₃SiO[-SiR₂O]ₙ-[SiHRO]ₘ-SiR'₃ mit m ≥ 0, n ≥ 0 und der Maßgabe, dass mindestens zwei SiH-Gruppen enthalten sein müssen, wobei R' die Bedeutung von H oder R haben kann. Es gibt demnach Vernetzer mit seitenständigen und endständigen SiH-Gruppen, während Siloxane mit R'= H, die nur endständige SiH-Gruppen besitzen, auch noch zur Kettenverlängerung verwendet werden. Als Vernetzungskatalysatoren kommen Platinkatalysatoren zum Einsat. HTV-Siliconkautschuke werden auch als Einkomponentensystem verarbeitet, wobei die Vernetzungsreaktion durch Temperaturerhöhung und in Anwesenheit von Peroxiden als Vernetzungskatalysatoren wie z.B. Acyl-, Alkyl- oder Arylperoxiden induziert wird. Peroxidvernetzende HTV-Siliconkautschuke erhält man durch die Vernetzung von gegebenenfalls mehrfach mit ethylenisch ungesättigten Gruppen, vorzugsweise Vinylgruppen, substituierten Organopolysiloxanen. Geeignete HTV-Siliconkautschuke sind im Handel erhältlich, beispielsweise die entsprechenden ELASTOSIL® R- oder ELASTOSIL® R plus-Typen der Wacker Chemie AG.

In jüngster Zeit sind zudem noch spezielle HTV- und RTV-1-Siliconkautschuke im Handel erhältlich, welche über die beschriebene Additionsreaktion vernetzt werden, indem spezielle Platin-Komplexe bzw. Platin-/Inhibitor-Systeme thermisch und/oder photochemisch aktiviert werden und somit die Vernetzungsreaktion katalysieren. Derartige Systeme sind beispielsweise als ELASTOSIL® R-Typen, ELASTOSIL® RT-Typen und Semicosil®-Typen bei der Wacker Chemie AG erhältlich.

Geeignete Materialien sind auch Siliconhybridpolymere. Siliconhybridpolymere sind Copolymerisate oder Pfropfcopolymerisate von Organopolymerblöcken, beispielsweise Polyurethan, Polyharnstoff oder Polyvinylestern, und Siliconblöcken, im allgemeinen auf Basis von Polydialkylsiloxanen der obengenannten Spezifikation. Beispielsweise werden thermoplastische Siliconhybridpolymere in EP 1412416 B1 und EP 1489129 B1 beschrieben, deren diesbezügliche Offenbarung auch Gegenstand dieser Anmeldung sein soll. Derartige Siliconhybridpolymere werden als Thermoplastische Siliconelastomere (TPSE) bezeichnet und sind im Handel erhältlich, beispielsweise die entsprechenden GENIOMER®-Typen der Wacker Chemie AG.

Siliconharze sind ebenfalls geeignete Materialien für die äußere Siliconmatrix B. Im allgemeinen enthalten die Siliconharze Einheiten der allgemeinen Formel R_{b}(RO)_{c}SiO_{(4-b-c)/2}, worin
b gleich 0, 1, 2 oder 3 ist,
c gleich 0, 1, 2 oder 3 ist,
mit der Maßgabe, dass b+c ≤ 3 ist,
und R in der oben dafür angegebenen Bedeutung,
welche ein hoch vernetztes Organosilicon-Netzwerk aufbauen. Geeignete Siliconharze sind im Handel erhältlich, beispielsweise die entsprechenden SILRES®-Typen der Wacker Chemie AG.

Geeignet für die Siliconmatrix B schließlich sind auch strahlungshärtende Acryl-, Epoxy- oder Vinylether-funktionelle Silicone, die mit Radikalbildnern oder kationischen Photoinitiatoren ausgehärtet werden.

Bevorzugte Materialien für die äußere Siliconmatrix B sind die genannten RTV-2-Siliconkautschuke, HTV-Siliconkautschuke und die Siliconhybridpolymere.

Die Eigenschaften der Siliconmatrix B können durch Modifizierung mit Additiven optimiert werden. Beispielsweise durch den Einsatz von Bioziden, wie Algiziden, Bakterioziden oder Fungiziden. Durch die Zugabe von Füllstoffen kann der Härtegrad eingestellt werden, wobei bei der Füllstoffauswahl darauf zu achten ist, dass die Transparenz nicht eingeschränkt wird, weshalb Füllstoffe auf Basis von Siliconharzpartikeln oder Nanopartikeln bevorzugt werden.

Die innere Siliconmatrix A kann von einer oder mehreren äußeren Siliconmatrices B umgeben sein. Die Schichtdicke der äußeren Siliconmatrix B hängt davon ab, wieviele Siliconmatrices B gebildet werden, und von der Anwendung der Leuchtkörper-Silicon-Formteile, und beträgt im allgemeinen zwischen 0,1 und 50 mm.

Das Leuchtkörper-Silicon-Formteil kann gegebenenfalls noch mit einem Topcoat C versehen sein, welcher auf die Siliconmatrix B bzw. auf die äußerste Siliconmatrix B aufgetragen wird. Der Topcoat dient dazu die Kratzfestigkeit und/oder Schmutzabweiseung und/oder die antistatischen Eigenschaften zu verbessern. Bevorzugt werden als Topcoat C die genannten Siliconharze eingesetzt.

Eine detailierte Übersicht über Silicone, ihre Chemie, Formulierung und Anwendungseigenschaften findet sich beispielsweise in Winnacker/Küchler, "Chemische Technik: Prozesse und Produkte, Band 5: Organische Zwischenverbindungen, Polymere",Seite 1095-1213, Wiley-VCH Weinheim (2005).

Die Herstellung der inneren Siliconmatrix A kann beispielsweise mittels Verfüllen, Vergießen oder Transfer-Molding erfolgen, je nach Gestalt des Leuchtkörper-Silicon-Formteils. Die Herstellung der Siliconmatrix B kann beispielsweise mittels Vergießen, Extrusion, Cast-Molding, Compression Molding oder Spritzguss erfolgen, je nach Gestalt des Leuchtkörper-Silicon-Formteils. Die optionale Beschichtung mit einem Topcoat kann beispielsweise mittels Beschichten wie z.B. Tauchen, Gießen, Streichen oder Besprühen erfolgen.

Zur Herstellung eines schlauchförmigen Formteils kann beispielsweise so vorgegangen werden, dass ein, mit einer LED-Kette ausgerüsteter, Siliconkautschuk-Schlauch (Siliconmatrix B), unter Vakuum, blasenfrei mit einem Silicongel als Siliconmatrix A befüllt wird, dieses danach vernetzt und der so erhaltene LED-Siliconmatrix-Schlauch anschließend mit einem RTV-Siliconkautschuk verschlossen wird. Bei der Herstellung von schlauchförmigen Leuchtkörper-Silicon-Formteilen kann auch so vorgegangen werden, dass anstelle eines Silicongels ein Siliconöl als Siliconmatrix A eingefüllt wird. Die übrigen Schritte werden analog der Vorgehensweise mit Silicongel ausgeführt. Eine weitere Alternative zur Herstellung von schlauchförmigen Formteilen besteht darin, nach dem Extrusionsverfahren Silicongel als Siliconmatrix A und HTV-Siliconkautschuk als Siliconmatrix B zu verarbeiten.

Zur Herstellung von flächigen Leuchtkörper-Silicon-Formteilen wird als Siliconmatrix B ein HTV-Siliconkautschuk mittels Compression-Molding oder Transfer-Molding zu einer Halbschale verarbeitet. In diese Halbschale werden handelsübliche LED-Ketten oder handelsübliche, mit LEDs bestückte Kunststoffleisten in beliebiger Anordnung abgelegt. Anschließend wird ein Silicongel so eingegossen, dass die LEDs vollständig von Silicongel umschlossen sind, welches die Siliconmatrix A bildet. Das Silicongel wird vernetzt und entgast, und das Formteil mit einer Deckelplatte aus dem gleichen Material wie die Halbschale abgeschlossen.

Alternativ dazu kann auch so vorgegangen werden, dass mittels Compression oder Transfer-Molding eine Platte aus HTV-Silicon gefertigt wird, und diese Platte dann an den Rändern mit einem standfesten RTV-Siliconkautschuk, welcher anschließend zu einem festen Steg vernetzt wird, versehen wird, um die Halbschalengeometrie zu erhalten. Die übrigen Schritte entsprechen dem obigen Vorgehen.

Eine weitere Alternative zur Herstellung von flächigen Teilen besteht darin, nach dem Injection Molding Verfahren zu arbeiten und LSR-Siliconkautschuk für die Herstellung der Halbschale bzw. Platten einzusetzen.

Bei dem Einsatz von Siliconhybrid-Polymeren kann ein Extruder mit einer Leuchtkörper-Kette beschickt werden und das Siliconhybrid-Polymer zu einem die Kette ummantelnden Formteil extrudiert werden, wobei simultan der Zwischenraum zwischen Kette und Siliconhybrid-Formteil mit Siliconöl befüllt wird.

Die erfindungsgemäßen Leuchtkörper-Silicon-Formteile bestechen durch deren Anwendungsvielfalt. Generell kann damit jedwede Lichteinheit in geschützter Form in verschiedene Applikationen gebracht werden.

Bei der Herstellung von LED-Silicon-Formteilen besteht ein wesentlicher Vorteil darin, dass auf die Verkapselung von LEDs mit Silicon im Vorfeld verzichtet werden kann und unverkapselte LEDs als Leuchtkörper verarbeitet werden können.

Die drei Hauptanwendungsfelder sind die reine Beleuchtung im Sinne der Dekoration und des Schutzes, das Initiieren von chemischen oder biologischen Reaktionen und das Markieren unter schwierigen Bedingungen.

Denkbare Anwendungen im Sinne der Dekoration wären beleuchtetes Eis, in Teppich eingewebte LED-Silicon-Formteile, in Aquarien, Saunen, Pool/Badewannenbeleuchtungen, als beleuchtete Dekofugen und in jegliche Form von Beleuchtungsschmuck. Anwendungen zum Schutz von Leben und Gesundheit sind in Schwimmwesten, an Treppenkanten, in und an Sportgeräten und in Kraftfahrzeugen möglich.

Chemische Reaktionen und/oder biologische Reaktionen können z.B. durch spezifische Wellenlängen des Lichtes im ultravioletten, visuellen oder im infraroten Bereich ausgelöst werden. Bindet man den geeigneten LED-Leuchtkörper in die Siliconmatrizes ein, kann man Wachstumsreaktionen von Pflanzen oder Früchten, z.B. in Gewächshäusern oder Dunkelräumen, das Abtöten von Pflanzen und Mikroorganismen, z.B. durch Dermatologische UV-Westen, -Decken oder das einfache Erhitzen von reaktiven Mischungen auslösen. Durch die hohe Inertheit des Siliconkörpers läßt sich dies in sauren, basischen, salzigen, mechanisch belasteten und sterilisierten Medien durchführen.

Das Markieren im Sinne eines Leitprinzips kann in Schiffs- und Hafenbeleuchtungen, auch unter Wasser, in mobilen Flugbahnabgrenzungen, im Kennzeichnen von Schläuchen, Rohren oder Kabeln in Raffinerien, als Angelzubehör und an Schildern vollzogen werden.

Bevorzugt werden die erfindungsgemäßen Leuchtkörper-Silicon-Formteile unter feuchten Bedingungen oder direkt in Flüssigkeiten angewendet. Besonders bevorzugt sind Leuchtkörper-Silicon-Formteile, die mit UV-LEDs bestückt sind und in wässrigen Medien zum Bestrahlen von pflanzlichen Massen oder zum Desinfizieren von Wasser hergenommen werden.

Bringt man Leuchtkörper-Silicon-Formteile, insbesondere LED-Silicon-Formteile, spezifischer Wellenlänge in Bioreaktoren zur Herstellung von Biomassen, insbesondere zur Algenzucht ein, kann, durch die Eindringtiefe des Lichtes und durch ein Pulsen des Lichtes zur Erzeugung von Hell- und Dunkelzonen, das Wachstum der Algen erheblich gesteigert werden. Weiterhin können UV-LED-Silicon-Formteile zur Desinfektion von mit Wasser gefüllten Behältnissen, wie z.B. in medizinischen Geräten, Emulgieranlagen, Rohren und Schläuchen hergenommen werden. In Kombination mit einer Solarzelle ist die Bereitstellung einer mobilen Trinkwasseraufbereitungsanlage möglich.

Mit den Leuchtkörper-Silicon-Formteilen stehen Strahlungskörper zur Verfügung, welche wegen der Resistenz von Siliconen gegenüber unterschiedlichsten Ausseneinflüssen universell einsetzbar sind. Ein großer Vorteil des modularen Aufbaus auf Basis einer inneren Siliconmatrix A und mindestens einer äußeren Siliconmatrix B besteht darin, dass es möglich wird das Formteil bezüglich Lichtausbeute und Resistenz zu optimieren. Während die innere Schicht bezüglich Lichtausbeute, Wärmeabfuhr und Schockabsorption optimiert ist, wird die äußere Siliconmatrix B bezüglich mechanischer Festigkeit, chemischer und biologischer, physikalischer (schmutzabweisend, kratzfest) Resistenz optimiert, unter Erhalt der notwendigen Transparenz. Mit einem einschichtigen Aufbau wäre dies, aufgrund der dabei auftretenden Wechselwirkungen zwischen den erforderlichen Additiven nicht in dieser Qualität zu verwirklichen, da das Anforderungsprofil für den Siliconanteil in Leuchtkörper-Nähe ganz unterschiedlich ist zum Anforderungsprofil an den Siliconanteil mit Kontakt zum umgebenden Medium.

### Beispiel 1:

Ein ca. 1 m langer Siliconschlauch, hergestellt per Extrusionsverfahren aus einem hochtransparenten, additionsvernetzenden Festsiliconkautschuk (ELASTOSIL® R plus 4305/50, Wacker Chemie AG) mit einer Shore-Härte A vom 50, einem Außendurchmesser von 12 mm und einer Wanddicke von 2 mm wurde in einer Vakuumkammer senkrecht aufgehängt, wobei das untere Ende des Schlauches mit einem Siliconstopfen dicht verschlossen wurde. Anschließend wurde vorsichtig eine 1 m lange LED-Modulleiste mit 60 LEDs (Fa. LED1.de, Dessau), die bei einer Spannung von 12 V Licht der bevorzugten Wellenlänge von 400 nm, in einem Abstrahlwinkel von 120° und einer Helligkeit von jeweils 100 mcd emittieren, so in den Siliconschlauch eingeführt, dass die Anschlußkabel und der Stecker, mit welchen die LED-Modulleiste zuvor versehen wurden, aus dem oberen Ende des Schlauches herausragten. Diese Anordnung wurde nun im Vakuum mit einer raumtemperaturvulkanisierenden, additionsvernetzenden Siliconelastomermischung (WACKER SilGel® 612 A/B) vergossen, welche eine Mischviskosität von ca. 1000 mPa*s (bei 23°C und 1013 mbar) aufweist, und bei Raumtemperatur innerhalb von 24 Stunden zu einem Silicongel mit einem Penetrationswert (DIN ISO 2137) von etwa 300 mm/10 vernetzt wird. Hierzu wurden zunächst die beiden Komponenten des Siliconvergußmaterials sorgfältig im Verhältnis 1:1 gemischt. Die so erhaltene Mischung wurde anschließend gemeinsam mit der Siliconschlauch/LED-Leisten-Anordnung in der Vakuumkammer für 30 Minuten und einem Vakuum von unter 50 mbar evakuiert, um absorbierte Luft, welche später im Vulkanisat zu störender Blasenbildung führen kann, zu entfernen. Das entgaste Siliconvergußmaterial wurde vorsichtig und im Vakuum in den die LED-Leiste enthaltenden Siliconschlauch gefüllt und im Vakuum 24 Stunden bei Raumtemperatur vulkanisiert. Danach wurde der Siliconschlauch, der die nun in Silicongel verkapselte LED-Leiste enthält, der Vakuumkammer entnommen. Abschließend entfernte man den eingangs erwähnten Siliconstopfen und versiegelte beide Enden des Siliconschlauches mit einem standfesten, selbsthaftenden Siliconkautschuk (Semicosil® 989/1K der Wacker Chemie AG), der bei 130°C zu einem transparenten bis opaken Vulkanisat mit einer Shore-Härte A von 55 vernetzt.

### Beipiel 2:

Die Durchführung erfolgte analog zu Beispiel 1, jedoch mit folgenden Unterschieden:
Als äußeres Matrixmaterial B wurde ein Siliconschlauch mit einer Shore-Härte A von 40 verwendet (ELASTOSIL® R plus 4305/40, Wacker Chemie AG).

Als inneres Matrixmaterial A wurde ein Siliconöl (WACKER® Siliconöl AK 100.000), bestehend aus Dimethylsiloxy- und Trimethylsiloxyeinheiten, mit einer Viskosität von 100.000 mPa.s (bei 23 °C und 1013 mbar), verwendet.

Das Einfüllen des Siliconöls erfolgte durch eine Kanüle "unter Spiegel von unten nach oben", um das Einbringen von Luftblasen zu verhindern. Anschließend wurden etwaige Lufteinschlüsse durch Evakuieren des mit Siliconöl gefüllten Schlauchs für 10 Minuten bei unter 50 mbar entfernt.

Die Siliconschlauchenden wurden statt mit einem einkomponentigen, hitzehärtenden Siliconkautschuk mit einem standfesten, selbsthaftenden RTV-1 Siliconkautschuk (ELASTOSIL® E 47 der Wacker Chemie AG), der bei Raumtemperatur durch Luftfeuchtigkeit zu einem transparenten bis opaken Vulkanisat mit einer Shore Härte A von 35 vernetzt, verschlossen.

### Beipiel 3:

Die Durchführung erfolgte analog zu Beispiel 1, wobei anstelle des aus Festsiliconkautschuk bestehenden Siliconschlauches ein per Extrusion aus thermoplastischem Siliconelastomer hergestellter Schlauch mit der Shore-Härte A von 50 eingesetzt wurde. Das hierfür verwendete, hochtransparente, thermoplastische, Harnstoffgruppen enthaltenden Basismaterial besitzt einen Siloxangehalt von 92 Gew.%, ein gewichtsmittleres Molekulargewicht Mw von ca. 120 000 g/mol, einen Erweichungspunkt von ca. 125°C, eine Schmelzviskosität bei 170 °C von etwa 100.000 Pa.s und ist von der Wacker Chemie AG unter dem Handelsnamen GENIOMER® 140 erhältlich. Weiterhin wurden die Schlauchenden nach dem Verguss mit dem Silicongel nicht mit einem einkomponentigen, hitzehärtenden Silicon verschlossen, sondern mit einem standfesten, selbsthaftenden RTV-1 Siliconkautschuk, der bei Raumtemperatur durch Luftfeuchtigkeit zu einem transparenten bis opaken Vulkanisat mit einer Shore-Härte A von 35 vernetzt (ELASTOSIL® E 47, Wacker Chemie AG).

### Beipiel 4:

Die Durchführung erfolgte analog zu Beispiel 3, wobei anstelle des dort als innere Siliconmatrix A eingesetzten Silicongels ein Siliconöl (WACKER® Siliconöl AK 1000), bestehend aus Dimethylsiloxy- und Trimethylsiloxyeinheiten, mit einer Viskosität von 1000 mPa.s (bei 23°C und 1013 mbar), verwendet wurde.

### Beispiel 5:

Die Durchführung erfolgte analog zu Beispiel 1, wobei aber, anstelle des in Beispiel 1 beschriebenen Vergussmaterials, für die innere Siliconmatrix A eine UV-aktivierbare Siliconvergußmasse (Semicosil® 912 UV der Wacker Chemie AG) verwendet wurde, die zu einem weichen Silicongel vernetzt. Das zweikomponentige Material hatte nach dem Mischen der beiden Komponenten im Verhältnis 9:1 eine Mischviskosität von 1000 mPa.s (bei 23°C und 1013 mbar) und lieferte ein gelartig weiches Vulkanisat mit einem Penetrationswert (DIN ISO 2137) von etwa 70 mm/10 (9,38 g Viertelkonus). Im Unterschied zu Beispiel 1 erfolgte die Vulkanisation der UV-aktivierbaren Siliconvergußmasse durch 5-sekundiges Belichten in einem UVA-Cube der Fa. Höhnle (Strahlungsintensität: 140 mW/cm²) und anschließendem Stehenlassen ohne UV-Bestrahlung bei Raumtemperatur. Das Material war nach 5 Minuten zu einem Silicongel durchvernetzt.

### Beispiel 6:

Eine transparente Halbschale (Außenmaße: 1000 x 500 x 20 mm; Wandstärke: 10 mm; Höhe der Vertiefung: 10 mm), bestehend aus einem Siliconelastomer mit einer Shore Härte A von 50 und hergestellt nach dem cast-molding-Verfahren (verwendet wurde eine gießfähige, bei Raumtemperatur vulkanisierbare Zweikomponentenmischung (ELASTOSIL® LR 7661 A/B, Wacker Chemie AG) welche nach Mischen der beiden Komponenten im Verhältnis 9:1 eine Mischviskosität von etwa 18.000 mPa.s hatte und innerhalb von 5 Minuten bei 165°C zu einem klar transparenten Vulkanisat vernetzte, wurde mit der Vertiefung nach oben flach in eine Vakuumkammer gelegt. Anschließend wurden in gleichmäßigem Abstand nebeneinander vier je 50 cm-lange und parallel miteinander verschaltete LED-Module des in Beispiel 1 beschriebenen Typs so in die Vertiefung der Halbschale verlegt, dass Anschlusskabel nebst Stecker, mit welcher die LED-Module versehen wurden, neben der Halbschale zu liegen kommen. Der Verguss dieser Anordnung erfolgte mit dem in Beispiel 1 beschriebenen, zu einem Gel vernetzenden Zweikomponentensilicon (WACKER SilGel® 612 A/B) und in gleicher Art und Weise wie oben beschrieben. Dabei ist darauf zu achten, dass die Halbschale vollständig mit dem Vergussmaterial gefüllt und die LED-Leisten vollständig vom Vergußmaterial umschlossen sind. Nach erfolgter Vulkanisation des Einkapselungsmatrials im Vakuum und bei Raumtemperatur wurde die Halbschale der Vakuumkammer entnommen. Anschließend wurde der obere Rand der Halbschale mit einem standfesten, selbsthaftenden RTV-1 Siliconkautschuk (ELASTOSIL® E 47, Wacker Chemie AG), der bei Raumtemperatur durch Luftfeuchtigkeit zu einem transparenten bis opaken Vulkanisat mit der Shore-Härte A von 35 vernetzt, bestrichen. Dannach wurde eine transparente Platte, mit dem Maß 1000 x 500 x 10 mmm und aus dem gleichen Siliconelastomer wie die Halbschale, bündig aufgelegt. Eingeschlossene Luft wurde durch seitliches Ausstreichen der Luftblasen entfernt, und es wurde für 24 Stunden bei Raumtemperatur vulkanisiert.

## Patentansprüche

1. Leuchtkörper-Silicon-Formteile, welche mehrere Leuchtkörper in einer Siliconmatrix eingeschlossen enthalten, wobei die Siliconmatrix aus einer inneren, weichen Siliconmatrix A gebildet wird, welche von einer oder mehreren, härteren Matrices B umgeben wird, **dadurch gekennzeichnet, dass** die Matrices B Siliconmatrices sind.

2. Leuchtkörper-Silicon-Formteile nach Anspruch 1, **dadurch gekennzeichnet, dass** als Leuchtkörper LED-Leuchtkörper enthalten sind.

3. Leuchtkörper-Silicon-Formteile nach Anspruch 1 oder 2, **dadurch gekennzeichnet, dass** mehrere Leuchtkörper, miteinander leitend verbunden, in Reihe und/oder parallel geschaltet sind.

4. Leuchtkörper-Silicon-Formteile nach Anspruch 1 bis 3, **dadurch gekennzeichnet, dass** die Leuchtkörper bei gleicher Wellenlänge emittieren.

5. Leuchtkörper-Silicon-Formteile nach Anspruch 1 bis 3, **dadurch gekennzeichnet, dass** Leuchtkörper mit unterschiedlicher Strahlungscharakteristik miteinander kombiniert werden.

6. Leuchtkörper-Silicon-Formteile nach Anspruch 1 bis 5, **dadurch gekennzeichnet, dass** die innere Siliconmatrix A eine Shore Härte A kleiner oder gleich 10 Shore-Härte-Punkte oder eine Viskosität von 1 bis 100x10⁶ mPa.s (bei 23°C und 1013 mbar) aufweist.

7. Leuchtkörper-Silicon-Formteile nach Anspruch 1 bis 6, **dadurch gekennzeichnet, dass** die Shore-Härte A der äußeren Siliconmatrix B mehr als 10 Shore-Härte-Punkte beträgt, und für den Fall, dass die innere Siliconmatrix A, ebenfalls aus einem bei Normalbedingungen festen Silicontyp besteht, die Differenz zwischen den Shore-Härten A von innerer Siliconmatrix A und äußerer Siliconmatrix B mindestens 5 Shore-Härte-Punkte beträgt.

8. Leuchtkörper-Silicon-Formteile nach Anspruch 1 bis 7, **dadurch gekennzeichnet, dass** für die innere Siliconmatrix A Siliconöle oder Silicongele eingesetzt werden.

9. Leuchtkörper-Silicon-Formteile nach Anspruch 1 bis 8, **dadurch gekennzeichnet, dass** für die äußere Siliconmatrix B RTV-2-Siliconkautschuke oder HTV-Siliconkautschuke oder Siliconhybridpolymere eingesetzt werden.

10. Leuchtkörper-Silicon-Formteile nach Anspruch 1 bis 9, **dadurch gekennzeichnet, dass** die Leuchtkörper-Silicon-Formteile noch mit einem Topcoat ausgerüstet sind.

11. Leuchtkörper-Silicon-Formteile nach Anspruch 1 bis 9, **dadurch gekennzeichnet, dass** diese in Form von Schläuchen, Rohren, Bänder, Platten oder in Form von Matten vorliegen.

12. Leuchtkörper-Silicon-Formteile nach Anspruch 1 bis 11, **dadurch gekennzeichnet, dass** die Leuchtkörper innerhalb der Siliconmatrix A in einer solchen Weise zueinander versetzt angeordnet werden, dass sie den Umgebungsraum vollständig und homogen ausleuchten.

13. Verfahren zur Herstellung von Leuchtkörper-Silicon-Formteilen nach Anspruch 1 bis 12, wobei die Leuchtkörper-Silicon-Formteile mit einer inneren, weichen Siliconmatrix A ausgerüstet werden, und mit einer oder mehreren, härteren Matrices B umgeben werden, **dadurch gekennzeichnet, dass** die Matrices B Siliconmatrices sind.

14. Verwendung von Leuchtkörper-Silicon-Formteilen nach Anspruch 1 bis 12 zur Beleuchtung.

15. Verwendung von Leuchtkörper-Silicon-Formteilen nach Anspruch 1 bis 12 zur Initiierung von chemischen oder biologischen Reaktionen.

16. Verwendung von Leuchtkörper-Silicon-Formteilen nach Anspruch 1 bis 12 zum Desinfizieren von Wasser.

17. Verwendung von Leuchtkörper-Silicon-Formteilen nach Anspruch 1 bis 12 in Bioreaktoren zur Herstellung von Biomassen, insbesondere zur Algenzucht.

18. Verwendung von Leuchtkörper-Silicon-Formteilen nach Anspruch 1 bis 12 in Kombination mit einer Solarzelle zur Bereitstellung einer mobilen Trinkwasseraufbereitungsanlage.

## Claims

1. Illuminant-silicone moldings which comprise a plurality of illuminants embedded in a silicone matrix, which silicone matrix is formed from an inner, soft silicone matrix A which is surrounded by one or more, harder matrices B, **characterized in that** the matrices B are silicone matrices.

2. Illuminant-silicone moldings according to Claim 1, **characterized in that** the illuminants present are LED illuminants.

3. Illuminant-silicone moldings according to Claim 1 or 2, **characterized in that** a plurality of illuminants, conductively connected to one another, are connected in series and/or in parallel.

4. Illuminant-silicone moldings according to Claims 1 to 3, **characterized in that** the illuminants emit at the same wavelength.

5. Illuminant-silicone moldings according to Claims 1 to 3, **characterized in that** illuminants with different radiation characteristics are combined with one another.

6. Illuminant-silicone moldings according to Claims 1 to 5, **characterized in that** the inner silicone matrix A has a Shore A hardness less than or equal to 10, or a viscosity of 1 to 100 x 10⁶ mPa.s (at 23°C and 1013 mbar).

7. Illuminant-silicone moldings according to Claims 1 to 6, **characterized in that** the Shore A hardness of the outer silicone matrix B is more than 10, and, in the case that the inner silicone matrix A likewise consists of a silicone type which is solid under standard conditions, the difference between the Shore A hardnesses of inner silicone matrix A and outer silicone matrix B is at least 5.

8. Illuminant-silicone moldings according to Claims 1 to 7, **characterized in that** silicone oils or silicone gels are used for the inner silicone matrix A.

9. Illuminant-silicone moldings according to Claims 1 to 8, **characterized in that** RTV-2 silicone rubbers or HTV silicone rubbers or silicone hybrid polymers are used for the outer silicone matrix B.

10. Illuminant-silicone moldings according to Claims 1 to 9, **characterized in that** the illuminant-silicone moldings are also equipped with a topcoat.

11. Illuminant-silicone moldings according to Claims 1 to 9, **characterized in that** they are present in the form of pipes, tubes, ribbons, sheets or in the form of mats.

12. Illuminant-silicone moldings according to Claims 1 to 11, **characterized in that** the illuminants within the silicone matrix A are arranged offset from one another in such a way that they completely and homogeneously illuminate the surrounding space.

13. Process for producing illuminant-silicone moldings according to Claims 1 to 12, wherein the illuminant-silicone moldings are equipped with an inner, soft silicone matrix A, and surrounded by one or more, harder matrices B, **characterized in that** the matrices B are silicone matrices.

14. Use of illuminant-silicone moldings according to Claims 1 to 12 for illumination.

15. Use of illuminant-silicone moldings according to Claims 1 to 12 for initiating chemical or biological reactions.

16. Use of illuminant-silicone moldings according to Claims 1 to 12 for disinfecting water.

17. Use of illuminant-silicone moldings according to Claims 1 to 12 in bioreactors for producing biomasses, especially for growing algae.

18. Use of illuminant-silicone moldings according to Claims 1 to 12 in combination with a solar cell for providing a mobile drinking water processing plant.

## Revendications

1. Pièces moulées silicone à corps luminescents, qui contiennent plusieurs corps luminescents inclus dans une matrice silicone, la matrice silicone étant constituée d'une matrice silicone A molle interne, qui est entourée d'une ou plusieurs matrices B plus dures, **caractérisées en ce que** les matrices B sont des matrices silicone.

2. Pièces moulées silicone à corps luminescents selon la revendication 1, **caractérisées en ce qu'**en tant que corps luminescents sont contenus des corps luminescents LED.

3. Pièces moulées silicone à corps luminescents selon la revendication 1 ou 2, **caractérisées en ce que** plusieurs corps luminescents sont en connexion conductrice entre eux, montés en série et/ou en parallèle.

4. Pièces moulées silicone à corps luminescents selon les revendications 1 à 3, **caractérisées en ce que** les corps luminescents émettent à la même longueur d'onde.

5. Pièces moulées silicone à corps luminescents selon les revendications 1 à 3, **caractérisées en ce que** des corps luminescents avec différentes caractéristiques de rayonnement sont combinés entre eux.

6. Pièces moulées silicone à corps luminescents selon les revendications 1 à 5, **caractérisées en ce que** la matrice silicone interne A présente une dureté Shore A inférieure ou égale à 10 points de dureté Shore ou une viscosité de 1 à 100×10⁶ mPa.s (à 23°C et sous 1 013 mbars).

7. Pièces moulées silicone à corps luminescents selon les revendications 1 à 6, **caractérisées en ce que** la dureté Shore A de la matrice silicone externe B est de plus de 10 points de dureté Shore, et dans le cas où la matrice silicone interne A consiste également en un type de silicone solide dans les conditions normales, la différence entre les duretés Shore A de la matrice silicone interne A et de la matrice silicone externe B est d'au moins 5 points de dureté Shore.

8. Pièces moulées silicone à corps luminescents selon les revendications 1 à 7, **caractérisées en ce que** pour la matrice silicone interne A on utilise des huiles de silicone ou des gels de silicone.

9. Pièces moulées silicone à corps luminescents selon les revendications 1 à 8, **caractérisées en ce que** pour la matrice silicone externe B on utilise des caoutchoucs silicone RTV-2 ou des caoutchoucs silicone HTV ou des polymères hybrides silicone.

10. Pièces moulées silicone à corps luminescents selon les revendications 1 à 9, **caractérisées en ce que** les pièces moulées silicone à corps luminescents sont de plus munies d'une couche de recouvrement (topcoat).

11. Pièces moulées silicone à corps luminescents selon les revendications 1 à 9, **caractérisées en ce qu'**elles se trouvent sous forme de tuyaux souples, de tubes, de bandes, de plaques ou sous forme de mats.

12. Pièces moulées silicone à corps luminescents selon les revendications 1 à 11, **caractérisées en ce que** les corps luminescents sont disposés de manière décalée les uns par rapport aux autres d'une telle façon à l'intérieur de la matrice silicone A qu'ils éclairent totalement et de façon uniforme l'espace environnant.

13. Procédé pour la production de pièces moulées silicone à corps luminescents selon les revendications 1 à 12, les pièces moulées silicone à corps luminescents étant munies d'une matrice silicone interne A molle et étant entourées d'une ou plusieurs matrices B plus dures, **caractérisé en ce que** les matrices B sont des matrices silicone.

14. Utilisation de pièces moulées silicone à corps luminescents selon les revendications 1 à 12, pour l'éclairage.

15. Utilisation de pièces moulées silicone à corps luminescents selon les revendications 1 à 12, pour l'amorçage de réactions chimiques ou biologiques.

16. Utilisation de pièces moulées silicone à corps luminescents selon les revendications 1 à 12, pour la désinfection de l'eau.

17. Utilisation de pièces moulées silicone à corps luminescents selon les revendications 1 à 12, dans des bioréacteurs pour la production de biomasses, en particulier pour la culture d'algues.

18. Utilisation de pièces moulées silicone à corps luminescents selon les revendications 1 à 12, en association avec une cellule solaire pour l'établissement d'une unité mobile d'épuration de l'eau potable.
